# EUROPEAN PATENT APPLICATION

(11) **EP 2 490 256 A1**
(43) Date of publication of application: **22.08.2012**
(21) Application number: 11155173.5
(22) Date of filing: 21.02.2011
(51) Int. Cl.: H01L 23/62, H01L 25/07

(54) **Electronic arrangement**

(71) Applicant: ABB Research Ltd., 8050 Zürich (CH)
(72) Inventor: Wildner, Franz, 5064, Wittnau (CH); Schulz, Nicola, 5300, Turgi (CH); Christen, Thomas, 5413, Brimenstorf (CH)
(74) Representative: ABB Patent Attorneys

(57) **Abstract**

The present invention relates to an electronic arrangement, comprising an electronic device (12) being located in an electric conduct (18), and a switching means (20) for disconnecting said conduct (18) or for closing a failure conduct (22) bypassing the electronic device (12), wherein the switching means (20) is activatable by heat impact, and wherein the electronic device (12) and the switching means (20) are connected by a connection (24) comprising a high energy material (28), the high energy material (28) being adapted to transfer activation energy from the electronic device (12) to the switching means (20). This electrical arrangement (10) provides improved safety properties with respect to a failure in the electronic device.

## Description

### Technical Field

The Invention relates to an electronic arrangement. In particular, the invention relates to an electronic arrangement comprising an electronic device with a switching means for reacting to a failure.

### Background Art

In some types of electronic devices, such as high power semiconductor modules, it has been found that a defect within the semiconductor leads to a short circuit of the device which is a desired effect. With large chip or wafer areas, this short circuit remains stable over a long time. If, for example, redundant thyristors are provided in a stack of thyristors connected in series, the remaining, intact thyristors withstand the voltage during the switched-off phase, and the stack remains operative. Defective thyristors can be replaced subsequently in the course of planned servicing work.

In a thyristor module, for example, the semiconductor, that is to say the silicon (Si), is in mechanical and electrical contact with and arranged between two molybdenum plates. Si has a melting temperature of 1420°C, wherein that of molybdenum is higher, and the intermetallic compounds of Si and molybdenum have a still higher melting point than Si. Thus, in the event of a defect, the silicon melts locally first of all and, as current flows, it forms a conductive channel composed of molten Si over the entire thickness of the semiconductor. This defect zone can propagate and/or move, but will only affect a small part of the chip area. In hermetically sealed housings, the molten Si does not oxidize but reacts with molybdenum to form a type of powder. This process continues until all the Si has been consumed, and may possibly extend over years.

In contrast to thyristor semiconductor components, insulated gate bipolar transistor (IGBT) chips, for example, are not produced as large-area units and, normally, a plurality of small-area individual chips are arranged isolated and alongside one another in the IGBT modules.

It has now been found that no persistently stable short circuits of the type described above can be expected with IGBT modules, for example. This is primarily due to the reduced area of the individual chips, and the small Si volume. The pseudo-stable phase of a short circuit lasts for only a short time in this case. Furthermore, the housings are often deliberately not hermetically sealed, so that the molten components can react with oxygen which negatively affects the short-circuit lifetime. Without any stable short-circuit path in the defective chip, the worst-case situation which can arise is as follows. The remaining chips in a module are switched off due to an inactive actuation unit and do not conduct electrical current. The current is then forced through the module, e.g. by the external electrical circuit inductance, leading to a plasma being formed, with a very high power density and temperature. This results in the entire module being destroyed with possible destructive impact on adjacent elements, such as water cooled heat sinks and electrical bus bars.

To avoid this problem, known from EP 0 989 611 B1 is a power semiconductor module which is formed from small-area individual chips and in which a short circuit of an individual chip does not lead to a total failure of the module. According to this prior art, a layer composed of a suitable material, for example, silver, is brought into direct contact with one or both of the main electrodes of the Si semiconductor. The material of this layer must form an eutectic mixture or an alloy possessing a lower melting temperature than its individual components with Si. In the event of a short circuit, the entire sandwich structure is heated and, once the melting point of the eutectic mixture or the alloy is reached, a conductive melt starts to form on the contact surface between the said layer and the Si. This zone can then expand over the entire thickness of the semiconductor, and thus form an electrically conductive channel. A sufficient electric contact is thereby provided by means of an electric contact piston.

Furthermore, known from EP 1 282 170 A1 is a short circuit proof semiconductor device. This device comprises a burning element with a high energy material. The high energy material may be activated such that an exothermal reaction occurs within the material. This has the effect of high temperatures to be created resulting in an alloy to be formed through the whole thickness and area of the semiconductor chip which reduces the electrical resistance of the alloy and improves the overall stability of the electrical short-circuit.

However, in some case, it might be insufficient to provide electronic devices, such as semiconductor devices, or modules like described above, to react to a failure, because a damage of the electronic arrangement may in some cases not completely be avoided.

### Summary of invention

It is an object of the present invention to provide an improved electronic arrangement which shall obviate at least one of the disadvantages known in the art.

In particular, it is an object of the present invention to provide an electronic arrangement comprising an electronic device in which the danger of the arrangement to be damaged in case of a failure is further minimized.

These objects are achieved by an electronic arrangement according to claim 1. Preferred embodiments of the present invention are defined in the dependent claims.

The invention relates to an electronic arrangement comprising an electronic device being located in an electric conduct and a switching means for disconnecting said conduct or for closing a failure conduct bypassing the electronic device, wherein the switching means is activatable by heat impact, and wherein the electronic device and the switching means are connected by a connection comprising a high energy material, the high energy material being adapted to transfer activation energy from the electronic device to the switching means.

According to the invention, a high energy material shall mean a material which performs an exothermal reaction due to an activation step, particularly due to an energy input. In detail, the high energy material may be activated by heat, vibration, mechanical stress, a flame, high local current density, a spark, an arc, a laser spot, needle pressing or the like. For example, the high energy material may perform an exothermal solid-state reaction resulting in an intermetallic phase formation.

The exothermal reaction thus may particularly be activated by an input of heat or mechanical energy and produces elevated temperatures. The amount of energy or temperature released may be adjusted to the desired application.

Additionally, a switching means according to the invention shall mean a means which is designed to and capable of opening or closing a conduct in order to disconnect a conduct from the remaining electronic arrangement, or to allow current to flow through a further conduct particularly to bypass an electronic device having a failure.

The electronic arrangement according to the invention comprises an electronic device which is located in an electric conduct. The electronic device may be a power electronic device, such as a high power semiconductor device. In this case, it may be a diode, a thyristor, a Metal Oxide Semiconductor Field-Effect Transistor (MOSFET), an Insulated Gate Bipolar Transistor (IGBT), a Bi-Mode Insulated Gate Transistor (BIGT), or a Reverse Conductive IGBT (RC IGBT), for example. Furthermore, the electronic device may be a capacitor, such as a high density capacitor, or a battery.

Examples for electronic devices which preferably are connected in series in electronic arrangements and thus may form stacks of electronic devices comprise power electronic modules, high energy density capacitors, or batteries, i.e. stacks, or series of electrochemical cells, or serial connections of supercaps for high voltages.

In contrast thereto, examples for electronic devices being preferably connected in parallel comprise parallel connections of power electronic devices or sub-elements thereof, capacitors, batteries, or laterally extended insulators having segmented electrodes with fuse connections between the segments.

A chip breakdown or another type of failure in such electronic devices is typically accompanied and succeeded by strong heat generation, electric arcing and the like. According to the invention, these events are used to trigger the reaction of the high energy material and thus of the switching means. The reaction to be performed by the switching means is dependent from the exact configuration of the electronic arrangement, i.e. if the electronic device is connected to other electronic devices in series or in parallel.

According to the invention, the switching means may react to a failure of the electronic device if this device is connected parallel as well as if it is connected in series.

In the first case, if the electronic device is connected in parallel with respect to further electronic devices in the electronic arrangement, the switching means may be designed for disconnecting the conduct in which the electronic device having a failure is located. This has the effect that the defect electronic device is decoupled and excluded from the working process of the further parallel electronic devices. The failure of an electronic device does thus not influence the working process of the further electronic devices and does not have a dangerous influence on the electronic arrangement as such.

In the second case, if the electronic device is connected in series, the switching means may close a failure conduct, which bypasses the electronic device having a failure. In detail, a failure conduct means a conduct which is open and thus not conducting in the normal working state of the electronic device. It is connected to the conduct, in which the electronic device is located, such, that the failure conduct bypasses, or bridges the electronic device and thus forms a short circuit between two connection points in said conduct being located upstream and downstream the defect device.

Consequently, if the electronic device fails, the latter is bridged by the failure conduct and the majority of current is guided through the failure conduct thus saving the defect electronic device and preventing too much heat to be formed and thus the whole electronic arrangement to fail.

Additionally, it may be preferred that the high energy material not only triggers a closing of the failure conduct, but additionally opens the conduct in which the electronic device having a failure is located. This will totally disconnect said conduct and thus decouple the defect electronic from the remaining electronic arrangement. The risk of the whole arrangement to be damaged, or destroyed, is thus further minimized.

Generally, such a switching means may comprise a meltable or evaporatable electric insulator which is placed close to the high energy material. Furthermore, other switching processes, such as melting, evaporation, other phase changes, thermal expansion, chemical reactions, or pyrotechnical reactions may be performed or a mechanical displacement may be triggered to open or close an electric conduct.

Due to the fact that the electronic device and the switching means are connected by a connection comprising a high energy material, the high energy material being adapted to transfer activation energy to the switching means, the switching means may be activated solely by the effect of the failure as such, i.e. heat formation, for example. The provision of sensors or the like is not necessary. The high energy material provides a propagating exothermal heat front through the connection activated from the local power input dissipated by the failure. The information of the failure is transported through the connection in terms of energy sufficient to trigger activation of the switching means.

Therefore, the location of the switching means is not limited. The activation energy is transported through the connection by means of the exothermic reaction which is performed by the high energy material. Due to high reaction speeds as well as velocities of the propagation of the reaction, the switching means may be located in direct vicinity to the electronic device, or spaced apart from the latter.

Consequently, particularly in the case of a serial connection, it is possible to provide one failure conduct with one switching means for a plurality of electronic devices. All said devices may then be connected to said switching means which will react in response to a failure of each element.

The electronic arrangement thus provides an overload protection means which may secure the electronic arrangement in case an electronic device has a defect, or failure, respectively. The arrangement may be secured in case both a serial or a parallel connection is provided. The transport of activation information and energy is triggered solely by the failure as such. The invention thus makes use of the synergistic effects of a switching means being activatable by heat impact and the usage of a high energy material for activating said switching means.

According to a preferred embodiment of the present invention, the high energy material is formed as a layer structure comprising a plurality of alternating layers. In detail, the layer structure may comprise two materials reacting with each other in an exothermic way. In this case, a connection is particularly easy to form leading to the arrangement as such to be designed essentially without limitations.

Additionally, the amount of energy release may be tailored to the desired application, i.e. especially with respect to the heat being required from the switching means to work properly. Furthermore, the activation both of the high energy material as well as of the switching means may be performed very localized thus concentrating the released energy.

With regard to the layer structure, it is especially preferred that it comprises alternating aluminium layers and nickel layers. Such a layer structure may perform an especially suitable exothermic reaction. In detail, an intermetallic structure comprising nickel and aluminium is formed, wherein temperatures of up to 1200 °C are formed. Consequently, the energy formed is high enough for most switching means to be activated and to work securely. Consequently, according to this embodiment, the reliability of the activation of the switching means is further maximized, whereas the danger of the electronic arrangement to be damaged is further minimized.

Additionally, such layers may be formed in an easy manner and they are inert with respect to each other and against oxidation at normal operation conditions. Consequently, the layer structure and thus the high energy material is producible cost-saving and has a long lifetime without the need of the material to be exchanged.

The layer structures, and especially the one formed of aluminium and nickel layers, furthermore may be designed to have a very long lifetime, also at elevated temperatures, for example at above 60°C or even at above 100°C. A further advantage of the usage of a high energy material comprising aluminium and nickel is the fact that an intermetallic structure is formed which reaction is completely solid-state. Consequently, no gas is formed which is especially preferred if the connection and thus the high energy material is at least partly located inside an electronic device.

According to a further preferred embodiment of the present invention, each layer comprises a mixed material zone. According to the invention, a mixed material zone shall mean a region of the layer, preferably at its outer side, in which it is formed not only of the main substance thereof, but additionally of a further material. Preferably, this material corresponds to the adjacent layer. Consequently, in the case of the alternating layers being formed of nickel and aluminium, the nickel layer comprises aluminium, preferably adjacent to the aluminium layer, whereas the aluminium layer comprises nickel in this zone, preferably adjacent to the nickel layer. This embodiment improves the activation of the high energy material and thus the start of the exothermic reaction. Consequently, the energy input being required for the exothermic reaction to start may be reduced, and furthermore adapted to the desired application. This embodiment thus allows a high flexibility of the design of the electronic arrangement according to the invention.

According to a still further embodiment of the present invention, the layers each have a thickness in the range of ≥ 1 nm to ≤ 100nm. This embodiment enables an especially fast reaction and thus a high velocity of propagation through the connection and thus from the electronic device to the switching means. In detail, due to the fact the layers have a thickness in the above identified range, even the material being located in the middle part of the respective layer is located close and in vicinity to the other respective layer. Consequently, a propagation of the reaction through the connection and thus to the switching means is improved allowing the reaction time of the switching means with respect to a failure, or defect, to occur to be minimized.

It is furthermore preferred, that the high energy material is arranged in the form of a foil or stripe. This is an especially easy way to form a connection between the electronic device and the switching means. Consequently, an arrangement according to this embodiment is especially easy and cost-saving to form.

According to a further preferred embodiment of the present invention, the high energy material is formed as a mixture of solid particles. In detail, it is preferred that the mixture of particles comprises materials being capable of reacting with each other in an exothermic way. As an example, the mixture may comprise nickel particles as well as aluminium particles. This embodiment allows tailoring the heat to be released by the exothermic reaction in an especially easy way by using the desired ratio and concentration of particles in the high energy material.

According to a still further embodiment of the present invention, the switching means comprises an electric fuse. This is an especially simple and cost saving means for a switching process. In detail, this arrangement may be used for disconnecting a conduct in case the electronic having a failure is connected to further electronic devices in parallel. In this embodiment, the high energy material will melt the meltable part of the electric fuse and will thus disconnect, or interrupt the current flow. The defect electronic device is thus disconnected from the further electronic devices to prevent them from getting a defect.

In an alternative preferred embodiment of the present invention, the switching means comprises a meltable electrical insulator separating two electric contacts, wherein at least one electric contact is spring loaded. This arrangement is especially preferred if the electronic arrangements are arranged in series. In detail, the high energy material may melt the insulator resulting in the electric contacts to come in contact due to the springload. Consequently, a failure conduct may be closed resulting in a high amount of current flowing through that conduct and thus reducing the current flow through the defect electronic device. Due to that bridging, the formed heat is strongly reduced preventing the whole electronic arrangement to be destroyed.

With this regard, it is especially preferred, that a solder material is provided on the surface of at least one electric contact. The heat provided by the high energy material may thus melt the solder material and form a secure connection between the two electric contacts. Consequently, not only a dry contact is formed, but a solder may be formed instead. Examples for solder materials comprise in a non limiting manner lead, tin, zinc or silver.

It is furthermore preferred that the electronic device comprises a power electronic device, a capacitor such as a high energy density capacitor, a battery or laterally extended insulators. For these electronic devices, the arrangement according to the invention is particularly suitable.

### Brief description of drawings

Additional features, characteristics and advantages of the subject-matter of the invention are disclosed in the subclaims, the figures and the following description of the respective figures and examples, which -in an exemplary fashion- show embodiments and examples of an electronic arrangement according to the invention.

In the figures:

Figure 1 shows a schematic view of an embodiment of the electronic arrangement according to the invention;

Figure 2 shows a schematic view of a further embodiment of the electronic arrangement according to the invention;

Figure 3 shows a schematic view of an embodiment of a connection connecting an electronic device and a switching means;

Figure 4 shows a schematic view of an embodiment of a switching means according to the invention.

### Description of embodiments

In the following, an electronic arrangement 10 according to the invention is schematically shown. It has to be noted that in different embodiments the same or comparable elements are referred to with the same numerals.

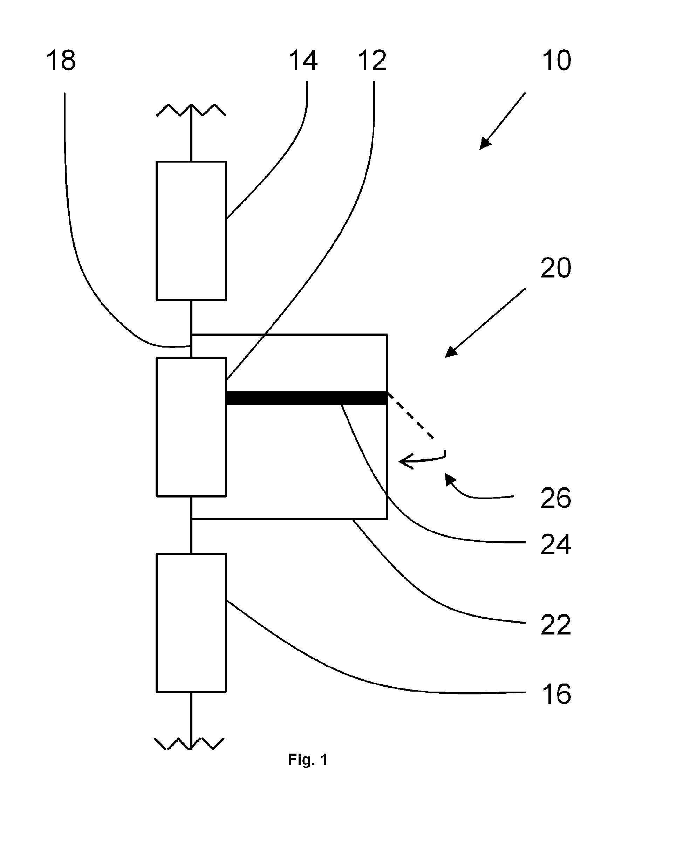

In figure 1, an electronic arrangement 10 according to an embodiment of the present invention is schematically shown. The electronic arrangement 10 comprises an electronic device 12. The electronic device 12 is connected to further electronic devices 14, 16, preferably further high power semiconductor devices, in series. Additionally, the electronic device 12 is located in an electric conduct 18.

The electronic arrangement 10 further comprises a switching means 20. The switching means 20 has as objective to react in response to a failure or a defect of the electronic device 12 and to secure the electronic arrangement 10 from being damaged or destroyed caused by said defect. In the embodiment according to figure 1, the switching means 20 is designed for closing a failure conduct 22 bypassing, or bridging the electronic device 12 having a failure. The switching means 20 may be any means being designed for performing the said reaction, i.e. to close the failure conduct 22. According to the invention, the switching means 20 is activatable by heat impact.

The closing of the failure conduct 22 is schematically shown by the arrow 26 in figure 1. According to this, the failure conduct 22 is open in a normal working mode of the electronic arrangement 10. This is visualized by the dashed line of the switching means 20. In case of a failure, the switching means 20 closes the failure conduct 22, which is visualized by the continuous line of the switching means 20. Consequently, by closing the failure conduct 22, the majority of current will flow through the failure conduct 22, and not through the defect electronic device 12, which reduces the heat being produced and in turn saves the electronic arrangement 10 from damages.

It is furthermore possible that in turn the electric conduct 18 is opened resulting in the defect electronic device 12 being completely currentless.

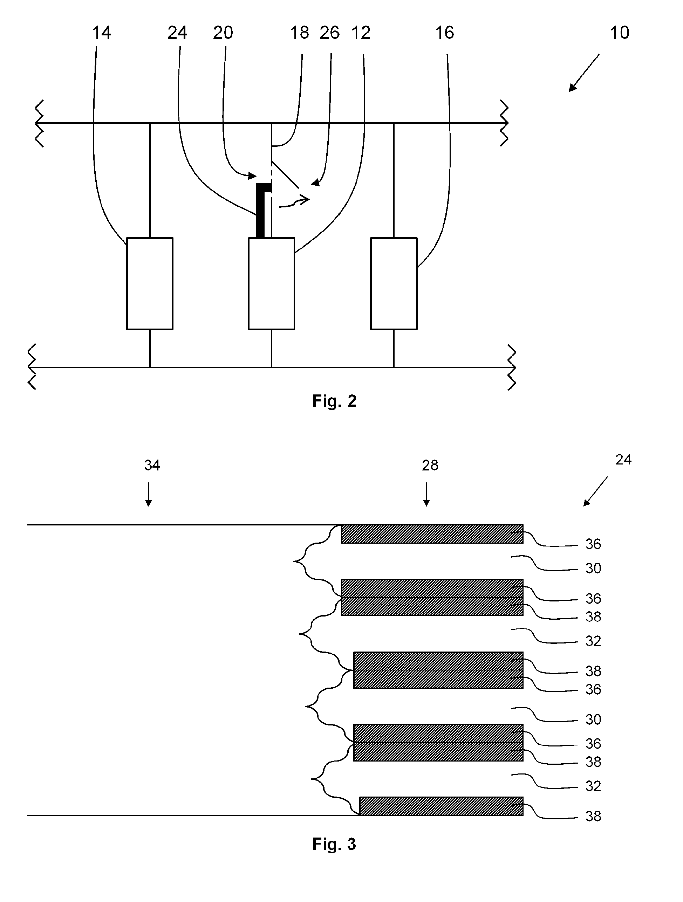

In an alternative embodiment, like shown in figure 2, the arrangement 10 according to the invention again comprises electronic devices 12, 14, 16, which, according to figure 2, are arranged in a parallel arrangement. Again, the electronic device 12, which, for a descriptive purpose, has a defect, or a failure, respectively, is arranged in a conduct 18.

According to the invention, the electronic arrangement 10 again comprises a switching means 20, which has as objective to react in response to a failure or a defect of the electronic device 12 and to secure the electronic arrangement 10 from being damaged or destroyed caused by said defect. In the embodiment according to figure 2, the switching means 20 is designed for disconnecting the conduct 18 in which the electronic device 12, having a failure, is located. The switching means 20 may be any means being designed for performing the said reaction, i.e. to disconnect the conduct 18. According to the invention, the switching means 20 is activatable by heat impact.

According to figure 2, the conduct 18 is closed in a normal working mode of the electronic arrangement 10. This is visualized by the dashed line of the switching means 20. In case of a failure, the switching means 20 disconnects the conduct 18, which is visualized by the continuous line of the switching means 20 as well as by the arrow 26. Consequently, by disconnecting the conduct 18, the latter together with the electronic device 12 is decoupled from the remaining electronic arrangement 10 and furthermore no current will flow through this electronic device 12, which prevents heat from being produced and in turn saves the electronic arrangement 10 from damages or destruction.

According to the invention, to activate the switching means, the electronic device 12 is connected to the switching means 20 by a connection 24 comprising a high energy material 28, the high energy material 28 being adapted to transfer activation energy to the switching means 20. Consequently, the heat being formed by the defect, or failure, of the electronic device 12 starts an exothermic reaction of the high energy material 28 in the connection 24. This causes a reaction front of the exothermic reaction to move through the connection 24, thereby creating further increased temperatures. Due to the so formed elevated temperatures, the switching means 20 is activated and switches in the desired mode, like described above.

With respect to the connection 24, or the high energy material 28, respectively, the latter may comprise any material or material mixture, which is capable of forming an exothermic reaction propagating through the connection 24 and thus to transport the triggering information of the failure as well as the activation energy to the switching means 20.

For example, the high energy material may be an oxidizable material in combination with an oxidizing agent.

An especially preferred example of a connection 24 with a high energy material 28 is shown in figure 3. According to figure 3, the high energy material 28 is formed as a layer structure comprising a plurality of alternating layers 30 and 32. The layers 30, and 32, respectively, may be any layers which may react with each other like described above and may have a thickness in the range of ≥ 1 nm to ≤ 100 nm leading to a thickness of the whole structure in the range of ≥ 40µm to ≤ 80µm, for example. The layers 30, 32 may have the same thickness with respect to each other, or they may have different thicknesses. In detail, it is preferable to adapt the respective layer thickness to the reaction which will occur in order to let the complete material react with each other.

For example, the layers 30 may be aluminium layers, whereas the layers 32 may be nickel layers. Consequently, when the connection 24, or the high energy material 28, respectively, is locally exposed to an energy impact, such as a heat impact, an exothermic reaction between nickel and aluminium will occur to form an intermetallic structure. The reaction front will move through the connection 24, thereby reaching a velocity of 5-8 m/s, for example, and creating temperatures of up to 1200°C.

This is visualized in figure 3. At the downstream part of the connection 24, the latter comprises the high energy material 28 in unreacted state, i.e. in the layer structure like described above. However, at the upstream part of the connection 24, i.e. when the reaction front has propagated, the connection 24 comprises the reacted intermetallic structure 34.

At the border area, each layer 30, 32 preferably comprise a mixed material zone 36, 38. This mixed material zone 36, 38 comprises the substance of the respective layer 30, 32 as such, as well as a defined amount of the material of the other layer 32, 30. This decreases the activation energy and improves the speed of the exothermic reaction and thus improves the velocity of the reaction front.

The connection 24 may only consist of the high energy material 28. It may be formed as a foil, for example. However, other possibilities to form the high energy material are stripes, which may as well be formed of the layer structure and in form of wires, for example. Additionally, it is possible to use a mixture of solid particles to form the high energy material 28. In detail, a mixture of nickel and aluminium particles may be used to form a high energy material 28 in the form of a powder, which in turn may be formed into arbitrary shapes.

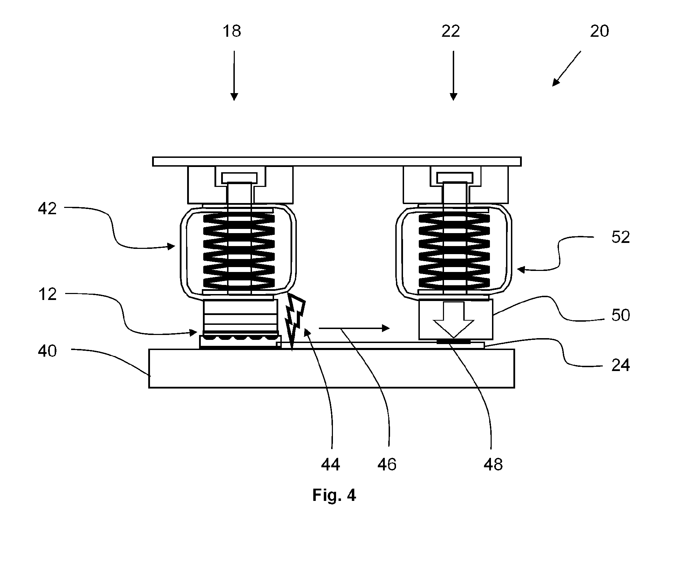

An example of a switching means 20 being designed for closing a failure conduct 22 is schematically shown in figure 4.

According to figure 4, an electronic device 12 is shown, which is connected to further electronic devices 14, 16, not shown as such, in series and which is located in a conduct 18. The electronic device 12 may be located on an collector plate 40, for example and a spring 42 may be provided for generating a sufficient electric contact.

In order to react to a failure of the electronic device 12, the connection 24 comprising the high energy material 28 is provided being in contact to the electronic device 12. The activation of the high energy material 28 is indicated by the flash 44, which results in an exothermic reaction to start and thus in a reaction front propagating through the connection 24 in the direction of the arrow 46. When the reaction front reaches an insulator 48, for example formed of polypropylene, the latter is molten by the heat formed by the high energy material 28, and thus an electric contact 50, being spring loaded by a spring 52 closes the failure conduct 22. The defect electronic device 12 is thus permanently bypassed.

Additionally, the heat released by the high energy material 28 may be used to form a soldered or brazed connection for a reliable electric bypass with a high current carrying capability. Materials, which may be located between the contacts to form the soldered connection, may comprise lead, tin, silver, or zinc.

The connection 24 may be arranged to connect a plurality of electronic devices 12, 14, 16 thus forming the possibility to use one bridge or bypass for a plurality of electronic devices 12, 14, 16.

In a further embodiment, if a parallel connection of a plurality of electronic devices 12, 14, 16 is provided, the switching means 20 may be designed to produce a resistance, e.g. via disconnecting contacts, at a failure of an electronic device. In especially easy manner, the switching means may in this case comprise a fuse.

While the invention has been illustrated and described in detail in the drawings and foregoing description, such illustration and description are to be considered illustrative or exemplary and not restrictive, the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

### Citation list

- 10: electronic arrangement
- 12: electronic device
- 14: electronic device
- 16: electronic device

- 18: conduct
- 20: switching means
- 22: failure conduct
- 24: connection
- 26: arrow
- 28: high energy material
- 30: layer
- 32: layer
- 34: intermetallic structure
- 36: mixed material zone
- 38: mixed material zone
- 40: collector plate
- 42: spring
- 44: flash
- 46: arrow
- 48: insulator
- 50: electric contact
- 52: spring

## Claims

1. Electronic arrangement comprising an electronic device (12) being located in an electric conduct (18), and a switching means (20) for disconnecting said conduct (18) or for closing a failure conduct (22) bypassing the electronic device (12), wherein the switching means (20) is activatable by heat impact, and wherein the electronic device (12) and the switching means (20) are connected by a connection (24) comprising a high energy material (28), the high energy material (28) being adapted to transfer activation energy from the electronic device (12) to the switching means (20).

2. Electronic arrangement according to claim 1, wherein the high energy material (28) is formed as a layer structure comprising a plurality of alternating layers (30, 32).

3. Electronic arrangement according to claim 2, wherein the layer structure comprises alternating aluminium layers and nickel layers.

4. Electronic arrangement according to claim 2 or 3, wherein each layer (30, 32) comprises a mixed material zone (36, 38).

5. Electronic arrangement according to any of claims 2 to 4, wherein the layers (30, 32) each have a thickness in the range of ≥ 1 nm to ≤ 100nm.

6. Electronic arrangement according to any of claims 2 to 5, wherein the high energy material (28) is arranged in the form of a foil or stripe.

7. Electronic arrangement according to claim 1, wherein the high energy material (28) is formed as a mixture of solid particles.

8. Electronic arrangement according to any of the preceding claims, wherein the switching means (20) comprises an electric fuse.

9. Electronic arrangement according to any of the preceding claims, wherein the switching means (20) comprises a meltable insulator (48) separating two electric contacts, wherein at least one electric contact (50) is spring loaded.

10. Electronic arrangement according to claim 9, wherein a solder material is provided on the surface of at least one electric contact (50).

11. Electronic arrangement according to any of the preceding claims, wherein the electronic device (12) comprises a power electronic device, a capacitor such as a high energy density capacitor, a battery or laterally extended insulators.
